# EUROPÄISCHE PATENTSCHRIFT

(11) **EP 0 778 673 B1**
(45) Veröffentlichungstag und Bekanntmachung des Hinweises auf die Patenterteilung: **24.05.2000**
(21) Anmeldenummer: 96118287.0
(22) Anmeldetag: 14.11.1996
(51) Int. Cl.: H03K 19/0185, H03K 19/0175

(54) **Integrierte Schaltung mit programmierbarem Pad-Treiber**
Integrated circuit with programmable pad-driver
Circuit intégré avec circuit d'attaque de sortie programmable

(30) Priorität: 08.12.1995 DE 19545904
(43) Veröffentlichungstag der Anmeldung: 11.06.1997
(73) Patentinhaber: SIEMENS AKTIENGESELLSCHAFT, 80333 München (DE)
(72) Erfinder: Eichfeld, Herbert, Dr., 80538 München (DE); Mattes, Heinz, Dr., 81739 München (DE)

(56) Entgegenhaltungen:
- EP-A- 0 315 473
- EP-A- 0 463 316
- DE-C- 4 224 804
- DE-C- 4 441 523
- US-A- 4 697 107
- US-A- 5 294 845

## Beschreibung

Um die Elektromagnetische Verträglichkeit (EMV) integrierter Schaltungen zu erhöhen, müssen die Pad-Treiber (Anschlußkontakt-Treiber) von integrierten Schaltungen auf die äußere Last angepaßt werden, um beispielsweise "weiche" Spannungs- und Stromverläufe auf den Signalleitungen zu erzielen.

Beispielsweise aus dem Paper 33.3 zur 28th ACM/IEEE Design Automation Conference, Seiten 567 bis 572 wird deutlich, daß es *den* EMV-optimalen Treiber für alle Lastfälle nicht gibt. Vielmehr hängt die Signalform sowohl von der Dimensionierung, insbesondere von der Treiberstärke I in Ampere und der Flankensteilheit dU/dt in V/sec, des Treibers ab als auch von der Art der Last, beispielsweise einer kapazitiven Last , einer offenen Leitung oder einem Leitungsnetz. Da eine integrierte Schaltung im allgemeinen nicht nur für eine bestimmte Anwendung mit klar definierter Lastumgebung eingesetzt wird, ist eine EMV-optimale Dimensionierung der Pad-Treiber nur anwendungsspezifisch möglich.

Aus der deutschen Patentschrift DE 44 41 523 C1 ist eine digitale Treiberschaltung für integrierte Schaltung bekannt, die an eine Lastkapazität durch Zuschalten entsprechend vieler Ausgangszweige angepaßt werden kann. Die Treiberschaltung ist vergleichsweise aufwendig, da neben den Ausgangszweigen Steuermittel zum Ansteuern der Ausgangszweige, eine Eingabevorrichtung zum Eingeben einer Maßzahl, ein Einstellmittel zum Ermitteln einer bestimmten Ausgangszweige zugeordneten Stellgröße aufgrund der Meßzahl und ein Schaltmittel zum Freigeben der bestimmten Ausgangszweige vorgesehen sind.

Ferner ist aus der deutschen Offenlegungsschrift DE 42 00 680 A1 eine Treiberschaltung bekannt, bei der durch eine Mehrzahl von Teiltreibern die Flankensteilheit der positiven und negativen Signalflanken getrennt eingestellt wird.

Aus der europäischen Anmeldeschrift 0 463 316 A1 ist eine Treiberschaltung mit selbstabstimmender Impedanzanpassung bekannt, bei der ein Speicher von einem Komparator, der ein Ausgangssignal mit einem Referenzsignal vergleicht, programmiert wird. Diese Treiberschaltung benötigt keine externen Programmiersignale aber, wegen des Komparators und einer vergleichsweise schwierigen Steuerlogik, relativ viel Chipfläche.

Die der Erfindung zugrunde liegende Aufgabe besteht nun darin, eine Integrierte Schaltung mit einem Pad-Treiber anzugeben, dessen Treibereigenschaften, wie zum Beispiel Treiberstärke I in Ampere und der Flankensteilheit dU/dt in V/sec, an eine jeweilige äußere Last flexibel angepaßt werden kann, wobei hierfür eine möglichst geringe zusätzliche Chipfläche anzustreben ist.

Diese Aufgabe wird erfindungsgemäß durch die Merkmale des Patentanspruchs 1 gelöst. Vorteilhafte Ausgestaltungen der Erfindung ergeben sich aus den Unteransprüchen.

Die Erfindung wird nachfolgend anhand der Zeichnungen näher erläutert. Dabei zeigt
- Figur 1: ein Blockschaltbild einer ersten Ausgestaltung der Erfindung,
- Figur 2: ein Blockschaltbild einer zweiten Ausgestaltung der Erfindung,
- Figur 3: ein Blockschaltbild einer dritten Ausgestaltung der Erfindung,
- Figur 4: ein Blockschaltbild einer vierten Ausgestaltung der Erfindung,
- Figur 5: ein Blockschaltbild einer fünften Ausgestaltung der Erfindung und
- Figur 6: ein Blockschaltbild einer Kombination verschiedener Ausgestaltungen der Erfindung.

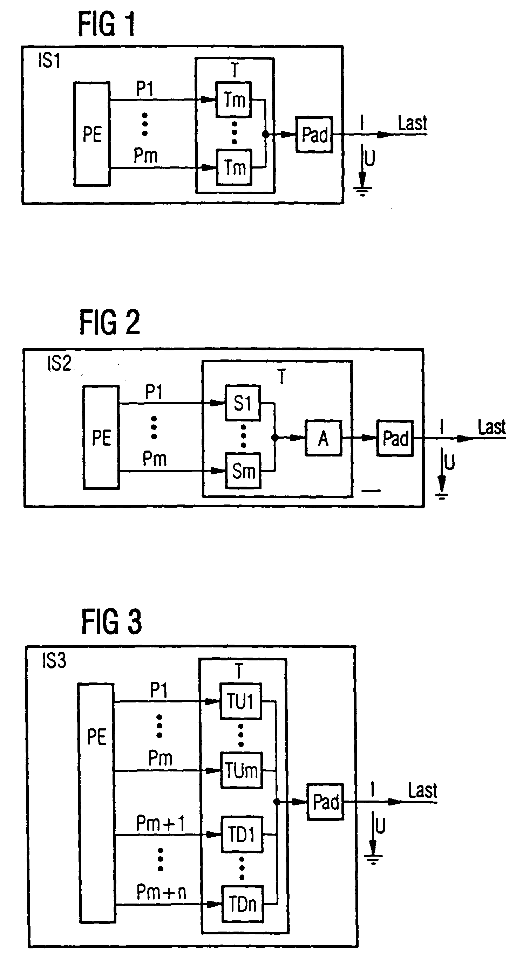

In Figur 1 ist eine erste Ausgestaltung IS1 einer erfindungsgemäßen integrierten Schaltung dargestellt, die eine Programmiereinheit PE, einem Treiber T und einem Anschlußkontakt Pad aufweist. Am Anschlußkontakt Pad liegt dabei eine Spannung U an und es fließt ein Treiberstrom I zur ebenso bezeichneten Last. Der Treiber T ist mit mehreren parallelgeschalteten Teil-Treibern T1..Tm ausgestattet, deren Ausgänge alle mit einem gemeinsamen Anschlußkontakt Pad verbunden sind und die mit Hilfe von Programmiersignalen P1...Pm aus einer Programmiereinheit PE je nach Bedarf aktivierbar sind. Ein deaktivierter Teil-Treiber ist an seinem Ausgang hochohmig. Die Gesamttreiberstarke I des Treibers T ist die Summe der Treiberstärken I1 + I2... aller aktivierten Teil-Treiber T1, T2 .. . Die Treiberstärken der einzelnen Teil-Treiber müssen dabei nicht gleichverteilt sein.

In Figur 2 ist eine zweite Ausgestaltung IS2 einer erfindungsgemäßen integrierten Schaltung dargestellt, die sich von der in Figur 1 dargestellten Ausgestaltung IS1 im wesentlichen nur dadurch unterscheidet, daß der Treiber T mit nur einer Ausgangsstufe A und einer Mehrzahl der Ausgangsstufe vorgeschalteten Ansteuereinheiten S1...Sm ausgestattet ist, wobei der Ausgang der Ausgangsstufe A mit dem Anschlußkontakt Pad verbunden ist und wobei die jeweiligen Eingänge der jeweiligen Ansteuereinheiten über Programmiersignale P1...Pm aus einer Programmiereinheit PE je nach Bedarf aktivierbar sind. Die Dimensionierung von A bestimmt dabei im wesentlichen die statische Treiberstärke I, die Dimensionierung der Ansteuereinheiten hingegen die Flankensteilheit dU/dt. Entsprechend läßt sich die Flankensteilheit des Treibers T über die Parallelschaltung mehrerer Ansteuerungen S1..Sm einstellen.

In Figur 3 ist eine dritte Ausgestaltung IS3 einer erfindungsgemäßen integrierten Schaltung dargestellt, die sich von der in Figur 1 Ausgestaltung IS1 im wesentlichen dadurch unterscheidet, daß der Treiber T über Teil-Treiber TU1...TUm für das Aufladen der Last und Teil-Treiber TD1...TDn für das Entladen der Last verfügt, wodurch sich die positive und negative Flanke des Ausgangssignals getrennt voneinander hinsichtlich der EMV optimieren läßt. Die Teil-Treiber TU1...TUm werden dabei durch die Programmiersignale P1...Pm und die Teil-Treiber TD1...TDm durch weitere Programmiersignale Pm+1 ... Pm+n aktiviert bzw. deaktiviert.

Darüberhinaus sind beliebige Kombinationen der Merkmale der ersten bis dritten Ausgestaltung möglich.

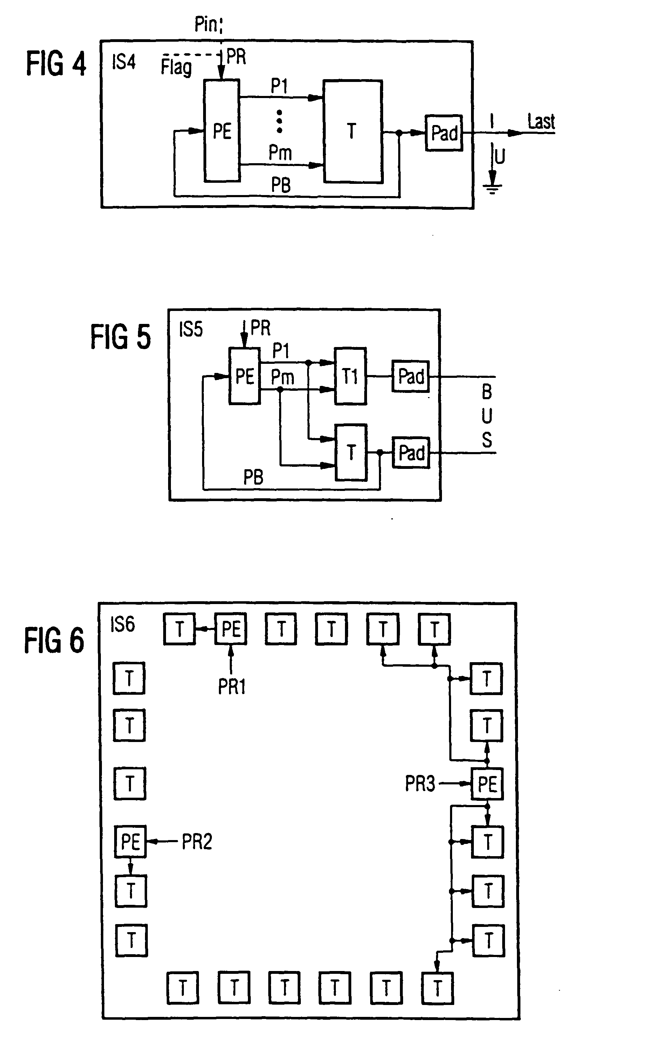

Die Programmierung der Programmiereinheit PE kann bereits vom Hersteller der integrierten Schaltung, z.B. als maskenprogrammierbares ROM, oder aber, wie in Figur 4 und 5 angedeutet, vom Platinenentwickler durchgeführt werden.

In Figur 4 ist eine vierte Ausgestaltung IS4 einer erfindungsgemäßen integrierten Schaltung dargestellt, die sich von der Ausgestaltung 1 im wesentlichen dadurch unterscheidet, daß ein Programmierbit PB zur Programmierung der Programmiereinheit PE über den Anschlußkontakt Pad der Programmiereinheit PE zuführbar ist und daß die Programmiereinheit PE durch ein Steuersignal PR aus einem Steuerregister Flag oder einem zusätzlichen Anschluß Pin ansteuerbar ist.

Damit die Programmierung vom Platinenentwickler durchführbar ist, muß der Treiber einen Programmier-Modus unterstützen. Betrachtet man zunächst nur die Programmierung eines einzelnen Pad-Treibers, so kann der Programmier-Modus durch das Steuersignal PR eingeleitet werden. Für z. B. PR = 1 übernimmt die Programmiereinheit PE das erste Programmierbit PB über den Anschlußkontakt Pad. Gleichzeitig deaktivieren die Programmiersignale P1..Pm den Treiber T. Danach wird PR = 0. Beim nächsten PR = 1 wird das nächste Programmierbit nach PE übertragen. Ein besonderer Vorteil liegt hier in der flächensparenden Programmiermethode.

In Figur 5 ist eine fünfte Ausgestaltung IS5 eine erfindungsgemäßen integrierten Schaltung dargestellt, die sich von der Ausgestaltung IS4 im wesentlichen dadurch unterscheidet, daß mindestens ein jeweiliger weiterer Treiber T vorgesehen ist, der ebenso mit den Programmiersignalen P1..Pm angesteuert wird, der mit mindestens einem weiteren Anschlußkontakt Pad verbunden ist und der jedoch keine Verbindung zwischen dem Anschlußkontakt Pad und der Programmiereinheit PE aufweist. Da nur diejenigen Pad-Treiber der integrierten Schaltung auf EMV optimierbar sein müssen, die dynamische Ausgangssignale, z. B. Adressen oder Daten, treiben, braucht nur eine Untermenge aller Treiber eine Programmiereinheit. Sind die Lastverhältnisse eines Adreß- oder Datenbusses für alle Leitungen ähnlich, so können alle zugehörigen Pad-Treiber hinsichtlich der EMV gleichartig programmiert werden. Das Programmierbit PB kann dabei wahlweise von irgend einem der Anschlußkontakte Pad zugeführt werden.

In Figur 6 ist eine sechste Ausgestaltung IS6 einer erfindungsgemäßen integrierten Schaltung dargestellt, die eine Kombination aus den in den vorhergehenden Figuren gezeigten Treibern darstellt, wobei Pad-Treiber T ohne zugehörige Programmiereinheit PE, verschiedene Pad-Treiber T mit getrennter Programmiereinheit und Gruppen von Pad-Treibern mit gemeinsamer Programmiereinheit vorhanden sind. Dies macht unterschiedliche Programmiersignale PR1 ..PR3 notwendig.

Die Programmiereinheit PE ist auf einer erfindungsgemäßen integrierten Schaltung, zum Beispiel im Pad-Rahmen, wo oft Lükken sind, integriert. Die Programmiereinheit PE speichert den logischen Zustand der Programmiersignale, da diese statisch an den Teil-Treibern anliegen müssen, damit sich deren Skalierung während des Betriebs nicht ändert. Die Speicherung der Programmiersignale kann in einem flüchtigen Speicher, zum Beispiel in einem RAM oder einem Flip-Flop, oder aber in einem nicht-flüchtigen Speicher, wie beispielsweise einem ROM, OTP, EEPROM oder Fuse erfolgen.

EMV-Regeln für die Programmierung der Programmiereinheit PE:

Um den Störeinfluß von Signalen möglichst gering zu halten, müssen schnelle unerwünschte Amplitudenänderungen, die durch Leitungsreflektionen entstehen, so gut wie möglich verhindert werden.
a) Durch die Dimensionierung der Treiberstärke (in Ampere) bei vorgegebener Betriebsspannung (in Volt) kann der Innenwiderstand der Signalquelle eingestellt werden. Es ist anzustreben, daß der differentielle Innenwiderstand der statischen Ausgangskennlinien des Treibers sowohl für den "LOW" als auch den "HIGH" Pegel dem Wellenwiderstand der angeschlossenen Leitung entspricht.
   Durch diese Maßnahme werden Reflektionen an der Signalquelle vermieden.
b) Durch die Dimensionierung der Flankensteilheit (in Volt/Sekunde) kann der Einfluß der am Leitungsende entstehenden Reflektionen eingestellt werden. Es ist anzustreben, daß eine von einem Treiber angesteuerte Leitung "elektrisch kurz" ist. Dies wird erzielt, wenn die erste am Leitungsende reflektierte Welle den Sender wieder erreicht, wenn die Anstiegs-/Abfallflanke ihren Endwert noch nicht erreicht hat. In diesem Fall wird die (am Leitungsende angeregte) Reflektion durch den Sender dominiert und abgeschwächt. Daraus ergibt sich die Regel: Die Anstiegs-/Abfallzeit sollte größer sein, als die doppelte Verzögerungszeit der angeschlossenen Leitung.

## Patentansprüche

1. Integrierte Schaltung mit mindestens einem Pad-Treiber, der eine Programmiereinheit (PE) und einer Mehrzahl von Teil-Treibern (T1..Tm) aufweist,
bei der eine bestimmte Treiberstarke und Flankensteilheit des Pad-Treibers dadurch einstellbar ist, daß abhängig von Ausgangssignalen (P1..Pm) der Programmiereinheit entsprechend viele ausgangsseitig mit einem gemeinsamen Anschlußkontakt (Pad) verbundene Teil-Treiber aktiviert/deaktiviert werden, und
bei der die Programmiereinheit einen Speicher aufweist, dessen Ausgangssignale die Ausgangssignale der programmiereinheit darstellen
dadurch gekennzeichnet, daß ein
serieller Eingang der Programmiereinheit mit dem gemeinsamen Anschlußkontakt (Pad) unmittelbar verbunden ist, wobei abhängig von einem Steuersignal (PR) ein Programmierbit-Signal (PB), das zum gemeinsamen Anschlußkontakt eingegeben wird, in den Speicher eingeschrieben wird, und
bei der die Programmiereinheit derart vorgesehen ist, daß aufgrund der Ausgangssignale der Programmiereinheit alle Teil-Treiber deaktiviert sind, während das Programmierbitsignal in den Speicher eingeschrieben wird.

2. Integrierte Schaltung nach Anspruch 1,
bei der die Flankensteilheit einer positiven Signalflanke dadurch getrennt von der Flankensteilheit einer negativen Signalflanke eingestellt wird, daß ein erster Teil (TU1..TUm) der Mehrzahl von Teil-Treibern nur für die positve Signalflanke vorgesehen und durch erste Ausgangssignale (P1..Pm) der Programmiereinheit aktiviert/deaktiviert wird und daß ein zweiter Teil (TD1..TDn) der Mehrzahl von Teil-Treibern nur für die negative Signalflanke vorgesehen und durch erste Ausgangssignale (Pm+1..Pm+n) der Programmiereinheit aktiviert/deaktiviert wird,

3. Integrierte Schaltung nach Anspruch 1 oder 2,
bei der in der integrierten Schaltung ein Register (Flag) vorgesehen ist an dessen Ausgang das Steuersignal anliegt.

4. Integrierte Schaltung nach Anspruch 1 oder 2,
bei der das Steuersignal (PR) über einen weiteren Anschlußkontakt (Pin) extern zugeführt wird.

5. Integrierte Schaltung nach einem der vorhergehenden Ansprüche,
bei der mindestens ein weiter Pad-Treiber (Tl) vorgesehen ist, der gemeinsam mit dem jeweiligen Pad-Treiber (T) durch durch die Ausgangssignale (P1..Pm) der jeweiligen Programmiereinheit (PE) angesteuert wird.

## Claims

1. Integrated circuit having at least one pad driver which has a programming unit (PE) and a plurality of subdrivers (T1..Tm), in which a particular driver strength and edge steepness can be set for the pad driver by activating/deactivating an appropriate multiplicity of subdrivers, whose outputs are connected to a common connection contact (Pad), on the basis of output signals (P1..Pm) from the programming unit, and in which the programming unit has a memory whose output signals are the output signals from the programming unit, characterized in that a serial input of the programming unit is directly connected to the common connection contact (Pad), a programming bit signal (PB) which is input to the common connection contact being written to the memory on the basis of a control signal (PR), and in which the programming unit is provided in such a manner that the output signals from the programming unit cause all the subdrivers to be deactivated while the programming bit signal is being written to the memory.

2. Integrated circuit according to Claim 1, in which the edge steepness of a positive signal edge is set to be distinct from the edge steepness of a negative signal edge by a first section (TU1..TUm) of the plurality of subdrivers being provided only for the positive signal edge and being activated/deactivated by first output signals (P1..Pm) from the programming unit, and by a second section (TD1..TDn) of the plurality of subdrivers being provided only for the negative signal edge and being activated/deactivated by first output signals (Pm+1..Pm+n) from the programming unit.

3. Integrated circuit according to Claim 1 or 2, in which the integrated circuit has a register (Flag) which has the control signal at its output.

4. Integrated circuit according to Claim 1 or 2, in which the control signal (PR) is supplied externally via a further connection contact (Pin).

5. Integrated circuit according to one of the preceding claims, in which there is at least one further pad driver (T1), which is driven, together with the respective pad driver (T), by the output signals (P1..Pm) from the respective programming unit (PE).

## Revendications

1. Circuit intégré ayant au moins un circuit d'attaque de bornes qui comporte une unité de programmation (PE) et plusieurs circuits d'attaque partiels (T1 à Tm),
dans lequel une certaine intensité d'attaque et une certaine pente de signal du circuit d'attaque de bornes peuvent être réglées par le fait que, en fonction de signaux de sortie (P1 à Pm) de l'unité de programmation, un nombre correspondant de circuits d'attaque partiels reliés côté sortie à une borne de connexion commune (Pad) peuvent être activés/désactivés, et
dans lequel l'unité de programmation comporte une mémoire dont les signaux de sortie représentent les signaux de sortie de l'unité de programmation,
caractérisé par le fait qu'une entrée sérielle de l'unité de programmation est reliée directement à la borne de connexion commune (Pad), un signal de bit de programmation (PB) entré à la borne de connexion commune étant enregistré dans la mémoire en fonction d'un signal de commande (PR), et
que l'unité de programmation est prévue de telle sorte que, sur la base des signaux de sortie de l'unité de programmation, tous les circuits d'attaque partiels sont désactivés pendant que le signal de bit de programmation est enregistré dans la mémoire.

2. Circuit intégré selon la revendication 1,
dans lequel la pente d'un front de signal positif est réglée séparément de la pente d'un front de signal négatif par le fait qu'une première partie (TU1 à TUm) des circuits d'attaque partiels n'est prévue que pour le front de signal positif et est activée/désactivée par des premiers signaux de sortie (P1 à Pm) de l'unité de programmation et qu'une deuxième partie (TD1 à TDn) des circuits d'attaque partiels n'est prévue que pour le front de signal négatif et est activée/désactivée par des deuxièmes signaux de sortie (Pm + 1 à Pm + n) de l'unité de programmation.

3. Circuit intégré selon la revendication 1 ou 2,
dans lequel il est prévu dans le circuit intégré un registre (Flag) à la sortie duquel se trouve le signal de commande.

4. Circuit intégré selon la revendication 1 ou 2,
dans lequel le signal de commande (PR) est envoyé de l'extérieur par l'intermédiaire d'une autre broche de connexion (Pin).

5. Circuit intégré selon l'une des revendications précédentes,
dans lequel il est prévu au moins un autre circuit d'attaque de bornes (T1) qui est commandé conjointement au circuit d'attaque de bornes (T) respectif par les signaux de sortie (P1 à Pm) de l'unité de programmation (PE) respective.
